# EUROPÄISCHE PATENTSCHRIFT

(11) **EP 3 245 481 B1**
(45) Veröffentlichungstag und Bekanntmachung des Hinweises auf die Patenterteilung: **30.01.2019**
(21) Anmeldenummer: 15813332.2
(22) Anmeldetag: 15.12.2015
(51) Int. Cl.: G01D 5/20, G01D 5/244, H03K 19/21, H03K 5/24

(54) **INDUKTIVE POSITIONSBESTIMMUNG**
INDUCTIVE POSITION DETERMINATION
DÉTERMINATION DE POSITION PAR INDUCTION

(30) Priorität: 16.01.2015 DE 102015200619
(43) Veröffentlichungstag der Anmeldung: 22.11.2017
(73) Patentinhaber: ZF Friedrichshafen AG, 88046 Friedrichshafen (DE)
(72) Erfinder: DEGEN, Joachim, 46517 Schermbeck (DE); JAHN, Jorg, 32257 Bünde (DE)
(86) Internationale Anmeldenummer: PCT/EP2015/079701
(87) Internationale Veröffentlichungsnummer: WO 2016/113058

(56) Entgegenhaltungen:
- EP-A1- 1 884 749
- EP-A2- 1 248 369
- DE-A1-102004 033 085
- DE-U1- 20 105 164
- DE-U1-202004 019 489

## Beschreibung

Die Erfindung betrifft eine induktive Positionsbestimmung. Insbesondere betrifft die Erfindung die Bestimmung einer relativen Position einer Einrichtung an Bord eines Kraftfahrzeugs.

An einem Kraftfahrzeug ist ein Wählhebel zur Beeinflussung einer in einem Getriebe eingelegten Gangstufe vorgesehen. Der Wählhebel kann durch den Fahrer in unterschiedliche Positionen gebracht werden, wobei der Wählhebel in einer Kulisse geführt sein kann. Dabei wird die Position des Wählhebels abgetastet und elektrisch bzw. elektronisch verarbeitet. Eine Steuereinrichtung kann dann das Getriebe auf der Basis des durch die Position des Wählhebels ausgedrückten Fahrerwunschs steuern. Die Position des Wählhebels kann dadurch abgetastet werden, dass an einer Konsole eine Reihe von Spulen angebracht sind und am Wählhebel, der gegenüber den Konsole beweglich ist, ein elektrisch leitfähiges Dämpfungselement. Je näher sich das Dämpfungselement an einer der Spulen befindet, desto stärker wird die Induktivität dieser Spule durch das Dämpfungselement verringert. Das Dämpfungselement besteht in der Regel aus einem gut leitfähigen Material wie Kupfer, Aluminium oder Messing.

DE 20 2004 019 489 U1 zeigt eine induktive Sensoreinheit, die nach diesem Prinzip arbeitet. Für dieses Messverfahren müssen jedoch üblicherweise relative große Induktivitäten verwendet werden. Soll die Spule als gedruckte Schaltung ausgeführt werden, so sind hierfür häufig mehrere Lagen zu verwenden, deren Herstellung aufwendig ist. Außerdem müssen die Spulen mit hoher Genauigkeit hergestellt und anschließend getestet werden, wodurch weitere Kosten in der Produktion entstehen können. Außerdem kann diese Art von Positionsmessung eine mehrstufige elektronische Verstärkung und ggf. noch eine Umkehrstufe erfordern.

DE 201 05 164 U1, EP 1 248 369 A2, DE 10 2004 033085 A1 und EP 1 884 749 A1 zeigen ebenfalls Vorrichtungen zur induktiven Positionsmessung.

Der Erfindung liegt die Aufgabe zugrunde, eine verbesserte Vorrichtung zur induktiven Positionsbestimmung anzugeben. Die Erfindung löst diese Aufgabe mittels einer Vorrichtung mit den Merkmalen des unabhängigen Anspruchs. Unteransprüche geben bevorzugte Ausführungsformen wieder.

Eine Vorrichtung zur induktiven Positionsbestimmung umfasst eine Spule, ein Element zur Beeinflussung eines Magnetfelds im Bereich der Spule, einen Signalgenerator zur Bereitstellung eines digitalen Signals und ein Verzögerungsglied mit einem Eingang und einem Ausgang, wobei das Verzögerungsglied auf der Basis der Spule aufgebaut ist und eine Verzögerungszeit zwischen einer Signalflanke am Eingang und einer korrespondierenden Signalflanke am Ausgang von der Induktivität der Spule abhängig ist. Ferner umfasst die Vorrichtung einen Vergleicher zur Bereitstellung eines digitalen Differenzimpulses, dessen Länge von einer Zeitdifferenz von korrespondierenden Signalflanken am Eingang und am Ausgang des Verzögerungsglieds abhängig ist, einen Integrator zur Bereitstellung einer Spannung in Abhängigkeit der Länge des Differenzimpulses, und eine Auswerteeinrichtung zur Bestimmung der Position des Elements bezüglich der Spule auf der Basis der Spannung.

Im Vergleich zu einer herkömmlichen Induktionsbestimmung kann die beschriebene Vorrichtung einfacher aufgebaut werden. Teile der Vorrichtung können mittels handelsüblichen Logikgattern implementiert werden. Die Vorrichtung kann unempfindlich gegenüber Bauteiltoleranzen sein. Außerdem kann sich die Vorrichtung zur Integration bzw. teilweisen Implementation durch einen programmierbaren Mikrocomputer eignen.

In einer bevorzugten Ausführungsform umfasst das Verzögerungsglied einen R-L-Tiefpass. So kann das Verzögerungsglied mit nur einem passiven Bauteil zusätzlich zur Spule aufgebaut werden. Das Verzögerungsglied kann so einfach, kostengünstig und kompakt ausgeführt sein.

Es ist weiterhin bevorzugt, dass der Signalgenerator abwechselnd steigende und fallende Signalflanken bereitstellt und der Vergleicher dazu eingerichtet ist, einen ersten Differenzimpuls in Antwort auf eine steigende Signalflanke und einen zweiten Differenzimpuls in Antwort auf eine fallende Signalflanke bereitzustellen, wobei die Differenzimpulse die gleiche Polarität aufweisen und der Integrator dazu eingerichtet ist, der Spannung in Abhängigkeit von Längen mehrerer Differenzimpulse bereitzustellen.

Durch die Auswertung von steigenden und fallenden Signalflanken kann eine Messspannung, die durch den Integrator bereitgestellt wird, erhöht sein oder schneller bereitgestellt werden. Ein Signal-Rausch-Verhältnis (SNR) kann dadurch verbessert sein.

In einer besonders bevorzugten Ausführungsform weisen Signalflanken am Eingang und am Ausgang des Vergleichers die gleiche Polarität auf und der Vergleicher umfasst eine Exklusiv-Oder-Logik (XOR-Logik). Dadurch kann die oben beschriebene Auswertung gegenläufiger Signalflanken einfach und kostengünstig implementiert werden. Die Logik kann als einfaches Standardgatter implementiert sein.

In einer weiteren Ausführungsform sind zwei Spulen vorgesehen, die jeweils einem Verzögerungsglied, einem Vergleicher und einem Integrator zugeordnet sind, wobei das Element so geformt ist, dass es die Magnetfelder beider Spulen beeinflusst und die Auswerteeinrichtung dazu eingerichtet ist, die Position des Elements auf der Basis von Spannungen beider Integratoren zu bestimmen.

Anders ausgedrückt kann die Position des Elements mit einer Auflösung bestimmt werden, die kleiner ist als der Abstand der beiden Spulen. Die Position kann beispielsweise aus einem Verhältnis der Spannungen abgeleitet werden. Weitere Ausführungsformen mit mehr als zwei gleichzeitig beeinflussten Spulen sind ebenfalls möglich.

Die Auswerteeinrichtung kann dazu eingerichtet sein, die Position des Elements auf der Basis der Spannung mittels einer vorbestimmten Kennlinie zu bestimmen. Die Kennlinie kann insbesondere einen Zusammenhang zwischen einer bestimmten Spannung und einem Abstand des Elements von der Spule angeben. In einer weiteren Ausführungsform kann auch ein Kennfeld vorgegeben sein, das eine Position des Elements bezüglich mehreren Spulen auf der Basis mehrerer Spannungen angibt. Nichtlinearitäten des Zusammenhangs können so leicht behandelt werden. Weist die Spule nur eine geringe Induktivität auf, beispielsweise wenn sie als Flachspule, etwa auf einer gedruckten Schaltung, ausgeführt ist, so müssen üblicherweise mehrere Differenzimpulse aufaddiert bzw. aufintegriert werden, um eine brauchbare Messspannung bereitzustellen. Dabei kann die Anzahl berücksichtigter Differenzimpulse variiert werden, um beispielsweise eine Nichtlinearität auszugleichen. Dies kann insbesondere bei einer Induktivität sinnvoll sein, die an der unteren Messgrenze der Vorrichtung liegt. In einer Ausführungsform ist der Integrator dazu eingerichtet, die Spannung auf der Basis einer Anzahl Differenzimpulse bereitzustellen, wobei die Anzahl in Abhängigkeit einer von dem Element unbeeinflussten Induktivität der Spule gewählt ist. In einer anderen Ausführungsform kann eine bekannte Referenzinduktivität anstelle der Spule verwendet werden, um zu bestimmen, wie groß die Anzahl berücksichtigter Differenzimpulse vorteilhafterweise sein muss. Eine derartige Kalibrierung kann einmalig oder zyklisch im Betrieb der Vorrichtung durchgeführt werden.

Bevorzugterweise ist eine Anordnung mehrerer Spulen vorgesehen, wobei jede Spule einem Verzögerungsglied, einem Vergleicher und einem Integrator zugeordnet ist, das Element auf einer Trajektorie beweglich ist, die durch Bereiche der Spulen führt und die Auswerteeinrichtung dazu eingerichtet ist, die Position des Elements auf der Basis von Spannungen der Integratoren bezüglich der Anordnung zu bestimmen. Beispielsweise können die Spulen so angeordnet sein, dass ihre Längsachsen die Trajektorie schneiden, wobei die Trajektorie bevorzugterweise in konstanter Höhe über den Spulen vorbeiführt. Es ist weiter bevorzugt, dass die Spulen bezüglich der Trajektorie gleiche Abstände aufweisen, insbesondere dann, wenn das Element dazu eingerichtet ist, mehr als eine Spule gleichzeitig zu beeinflussen. In dieser Ausführungsform kann die Position des Elements auf der Trajektorie einfach und relativ genau bestimmt werden.

Bevorzugterweise ist eine gemeinsame Auswerteeinrichtung für mehrere Integratoren vorgesehen. Die Auswerteeinrichtung kann insbesondere einen Analog-Digital-Wandler und einen programmierbaren Mikrocomputer umfassen. Es ist weiterhin bevorzugt, dass den Verzögerungsgliedern das Signal des Signalgenerators im Zeitmultiplexverfahren bereitgestellt wird. Dabei wird das Signal des Signalgenerators immer nur einem der Verzögerungsglieder bereitgestellt. Das Aufschalten des Signals auf die einzelnen Verzögerungsglieder kann beispielsweise durch die Auswerteeinrichtung gesteuert werden.

Die Spule kann eine Flachspule umfassen. Dadurch kann die Spule einfach, beispielsweise als gedruckte Schaltung aufgebaut sein. In einer bevorzugten Ausführungsform umfasst die Spule eine mehrlagige Flachspule, die beispielsweise in Form von unterschiedlichen Ebenen einer doppelseitigen oder Mehrebenen-Platine ausgebildet sein kann.

Es ist weiterhin bevorzugt, dass an der Spule ein weichmagnetischer Kern vorgesehen ist. Der weichmagnetische Kern kann im Fall der Flachspule insbesondere an der Oberseite, der Unterseite oder zwischen unterschiedlichen Ebenen der Spule angeordnet sein.

Die Erfindung wird nun mit Bezug auf die beigefügten Figuren genauer beschrieben, in denen:
- Fig. 1: ein Blockschaltbild einer Vorrichtung zur induktiven Positionserfassung;
- Fig. 2: ein Impulsdiagramm am Vergleicher der Vorrichtung von Fig. 1;
- Fig. 3: eine Anordnung von Spulen an der Vorrichtung von Fig. 1;
- Fig. 4: Kennlinien der Spule von Fig. 1;
- Fig. 5: eine Beispielschaltung für die Vorrichtung von Fig. 1; und
- Fig. 6: zu erwartende Spannungen an der Beispielschaltung von Fig. 5
darstellt.

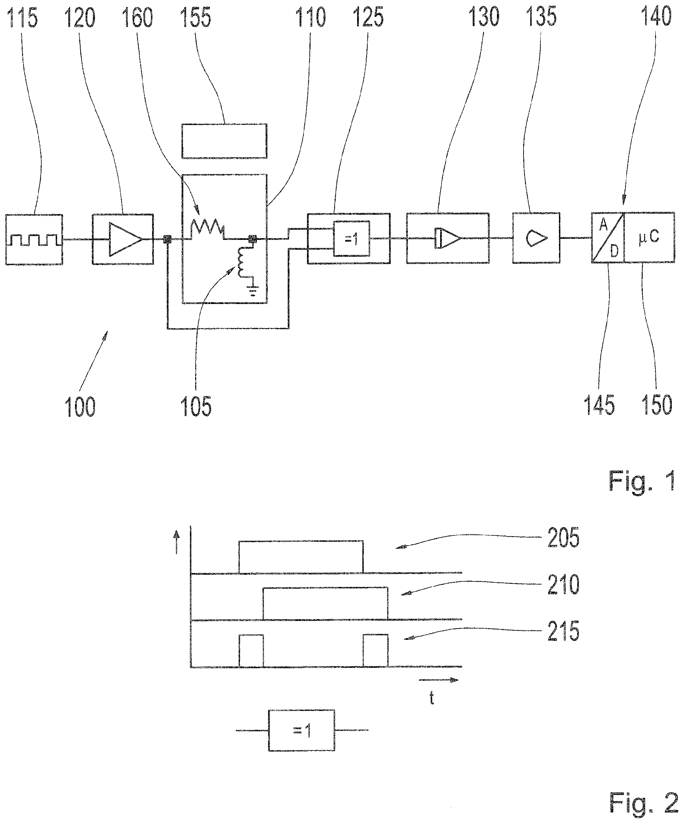

Figur 1 zeigt ein Blockschaltbild einer Vorrichtung 100 zur induktiven Positionserfassung. Die Vorrichtung 100 kann beispielsweise verwendet werden, um an Bord eines Kraftfahrzeugs eine Position eines Wählhebels für eine Gangstufe eines automatisierten Getriebes, eine Position eines verstellbaren Sitzes, eine Position eines verstellbaren Außenspiegels oder eine Position eines beweglichen Gaspedals zu bestimmen. Es können auch andere Positionen an Bord des Kraftfahrzeugs erfasst werden.

Die Vorrichtung 100 umfasst eine Spule 105, die Teil eines Verzögerungsglieds 110 ist, einen Signalgenerator 115, einen optionalen Puffer 120, einen Vergleicher 125, einen Integrator 130, einen optionalen Verstärker 135 und eine Auswerteeinrichtung 140, die insbesondere einen Analog-Digital-Wandler 145 und einen programmierbaren Mikrocomputer 150 umfassen kann. Außerdem ist ein Element 155 zur Beeinflussung eines Magnetfelds im Bereich der Spule 105 vorgesehen. Das Element 155, das beweglich zur Spule 105 angeordnet ist, wird unten noch genauer erläutert.

Der Signalgenerator 115 ist dazu eingerichtet, ein digitales Signal mit einer Signalflanke bereitzustellen. Die Signalflanke kann steigend oder fallend sein oder es können abwechselnd steigende und fallende Signalflanken ausgegeben werden, beispielsweise in Form eines Rechtecksignals. Der Signalgenerator 115 kann in einer Ausführungsform durch die Auswerteeinrichtung 140, insbesondere den Mikrocomputer 150, gesteuert oder implementiert sein. Der optionale Puffer 120 dient dazu, das bereitgestellte Signal zu verstärken bzw. die Ausgangsimpedanz des Signalgenerators 115 zu verringern.

Das Verzögerungsglied 110 ist in der dargestellten Ausführungsform als R-L-Tiefpass in Verschaltung mit einem Widerstand 160 dargestellt. Andere Ausführungsformen, die beispielsweise einen monostabilen Multivibrator umfassen, sind ebenfalls möglich. In jedem Fall ist das Verzögerungsglied 110 dazu eingerichtet, in Antwort auf eine Signalflanke an seinem Eingang eine weitere Signalflanke an seinem Ausgang bereitzustellen, wobei eine Zeitdifferenz, also ein zeitlicher Abstand, der beiden Signalflanken von der Induktivität der Spule 105 abhängig ist. Allgemein ist dabei bevorzugt, dass eine steigende Signalflanke am Eingang eine steigende Signalflanke am Ausgang und eine fallende Signalflanke am Eingang eine fallende Signalflanke am Ausgang bewirkt.

Der Vergleicher 125 stellt auf der Basis der Signale am Eingang und am Ausgang des Verzögerungsglieds 110 einen digitalen Differenzimpuls bereit, dessen Länge von der Zeitdifferenz zwischen einer Signalflanke am Eingang und einer dazu korrespondierenden Signalflanke am Ausgang des Verzögerungsglieds 110 abhängig ist. In der dargestellten, bevorzugten Ausführungsform weisen korrespondierende Signalflanken am Eingang und am Ausgang des Verzögerungsglieds 110 gleiche Polaritäten auf, eine steigende Flanke eines Eingangssignals bewirkt also nach der Verzögerungszeit eine steigende Flanke eines Ausgangssignals und eine fallende Flanke des Eingangssignals bewirkt nach der Verzögerungszeit eine fallende Flanke des Ausgangssignals. Dadurch kann der Vergleicher 125 als XOR-Logik, insbesondere als XOR-Gatter, beispielsweise in CMOS- oder TTL-Technologie, implementiert werden. Liegen andere Polaritäten bzw. Kombinationen von Polaritäten vor, kann ein anderes Gatter oder eine Kombination von Gattern als Vergleicher 125 verwendet werden.

Der Integrator 130 kann in einer einfachen Ausführungsform mittels eines Widerstands und eines Kondensators als RC-Glied ausgebildet sein. In einer anderen Ausführungsform kann der Integrator 130 auch durch einen entsprechend geschalteten Operationsverstärker realisiert sein. Der optionale Verstärker 135 kann ebenfalls durch einen Operationsverstärker realisiert sein, wobei der Verstärker 135 insbesondere dann entfallen kann, wenn der Integrator 130 auf der Basis eines Operationsverstärkers aufgebaut ist. Der Verstärker 135 verstärkt die durch den Integrator 130 bereitgestellte Spannung, deren Höhe von der Länge des Differenzimpulses des Vergleichers 125 abhängig ist.

Figur 2 zeigt ein Impulsdiagramm am Vergleicher 125 der Vorrichtung 100 von Figur 1. In horizontaler Richtung ist eine Zeit und in vertikaler Richtung eine Spannung angetragen. Ein erstes Signal 205 ist beispielhaft durch den Signalgenerator 115 bereitgestellt, ein zweites Signal 210 ist durch das Verzögerungsglied 110 auf der Basis des ersten Signals 205 bereitgestellt und ein drittes Signal 215 umfasst einen durch den Vergleicher 125 bereitgestellten Differenzimpuls.

Der Vergleicher 125, der als XOR-Gatter ausgebildet ist, schaltet seinen Ausgang auf logisch 1, wenn genau eines der Signale 205 und 210 logisch 1 und das andere logisch 0 ist. Dadurch werden ein erster Differenzimpuls zwischen der steigenden Signalflanke des ersten Signals 205 und der steigenden Signalflanke des zweiten Signals 210 sowie ein zweiter Differenzimpuls zwischen der fallenden Signalflanke des ersten Signals 205 und der fallenden Signalflanke des zweiten Signals 210 ausgegeben. Weisen die Signale 205 und 210 unterschiedliche Polaritäten auf, so kann eines der Signale 205 und 210 invertiert werden, um die Signale 205 und 210 mittels des Vergleichers 125 vergleichen zu können.

Wird die Spule 105 mit dem digitalen Signal des Signalgenerators 115 beaufschlagt, so bildet sich in ihrem Bereich ein Magnetfeld, das je nach Position des Elements 155 stärker oder schwächer beeinflusst wird. Dementsprechend ist die Induktivität der Spule 105 von der Position des Elements 155 abhängig. Die Induktion der Spule 105 bestimmt die Verzögerungszeit des Verzögerungsglieds 110 und dadurch die Länge jedes Differenzimpulses des dritten Signals 215. In einer Ausführungsform, in der das Element 155 die Induktivität der Spule 105 positiv beeinflusst, also bei Annäherung an die Spule 105 vergrößert, kann die Anwesenheit des Elements 155 im Bereich der Spule 105 daran erkannt werden, dass die Differenzimpulse des dritten Signals 215 eine vorbestimmte Länge erreichen.

Einer oder bevorzugterweise mehrere Differenzimpulse des dritten Signals 215 werden mittels des Integrators 130 aufintegriert, um eine Spannung bereitzustellen, deren Höhe von der Länge der Differenzimpulse des dritten Signals 215 abhängig ist. Im genannten Beispiel kann die Anwesenheit des Elements 155 im Bereich der Spule 105 daran erkannt werden, dass die Spannung des Integrators 130 einen vorbestimmten Schwellenwert übersteigt.

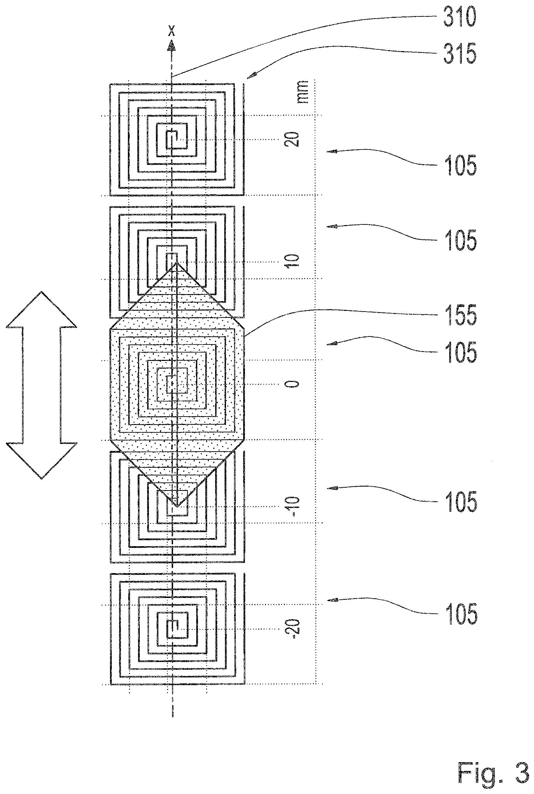

Figur 3 zeigt eine Anordnung 305 von Spulen 105 an der Vorrichtung 100 von Figur 1. Die beispielhaft dargestellte Anordnung 305 umfasst mehrere Spulen 105, die insbesondere als Flachspulen ausgeführt sein können. Statt der dargestellten rechteckigen Spulen können auch runde oder anders geformte Spulen 105 verwendet werden. Die Spulen 105 sind entlang einer Trajektorie 310 angeordnet, die wie dargestellt gerade verlaufen oder einer Kurve folgen kann. Bevorzugterweise schneiden Längsachsen der Spulen 105 die Trajektorie 310. Außerdem ist bevorzugt, dass die Spulen 105 dicht nebeneinander liegen. Optional kann an einer Spule 105 ein weichmagnetischer Kern 315 zur Vergrößerung der Spuleninduktivität vorgesehen sein. Im Fall von Flachspulen kann der weichmagnetische Kern 315 beispielsweise flächig unter oder über der Spule 105 angebracht sein.

Eine Trajektorie 310 verläuft durch Bereiche der Spulen 105. Insbesondere ist bevorzugt, dass die Trajektorie 310 durch Längsachsen der Spulen 105 verläuft, und zwar weiter bevorzugt in konstanter Höhe über den einzelnen Spulen 105. Dabei kann die Trajektorie 310 die Form einer beliebigen Kurve annehmen, auch beispielsweise kreisförmig. Das Element 155 zur Beeinflussung des Magnetfelds einer Spule 105 ist entlang der Trajektorie 310 beweglich angeordnet. Zur Bezugnahme auf die folgende Figur ist eine Position des Elements 155 entlang der Trajektorie 310 in der dargestellten, exemplarischen Ausführungsform in Millimetern angegeben.

Das Element 155 kann flach mit einer Dicke von unter einem Millimeter ausgebildet sein. Dabei sind seine Umrisse bevorzugterweise so gewählt, dass es die Oberfläche wenigstens einer Spule 105 überdecken kann. Bevorzugterweise sind seine Umrisse noch größer, sodass es zusätzlich wenigstens eine benachbarte Spule 105 gleichzeitig zu einem vorbestimmten Teil überdeckt.

Das Element 155 kann aus unterschiedlichen Materialien herstellbar sein und bei Annäherung an eine Spule 105 alternativ zur Verringerung oder Vergrößerung deren Magnetfelds beitragen, wie in der folgenden Figur gezeigt ist.

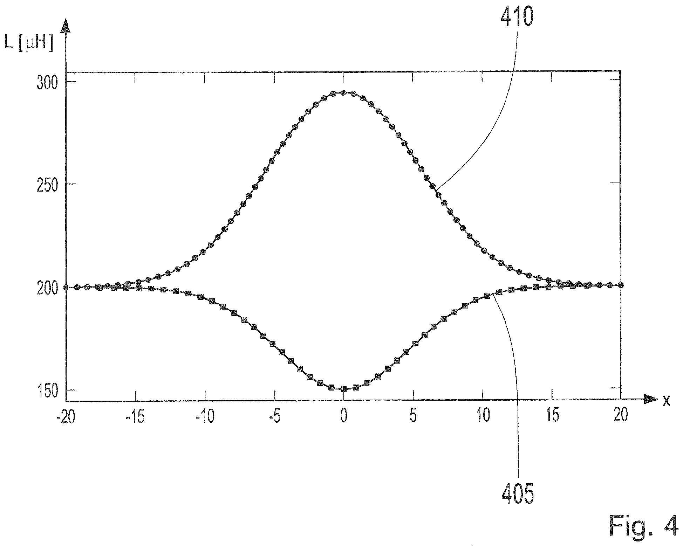

Figur 4 zeigt Kennlinien der Spule 105 von Figur 1. In horizontaler Richtung ist exemplarisch die Position des Elements 155 in der Darstellung von Figur 3 angetragen und in vertikaler Richtung ist eine Induktivität der Spule 105 angetragen.

Eine erste Kennlinie 405 betrifft ein Dämpfungselement 155, das insbesondere aus einem gut leitfähigen Material wie Kupfer oder Aluminium hergestellt sein kann. Eine zweite Kennlinie 410 betrifft ein Verstärkungselement 155, das insbesondere ein weichmagnetisches Material wie Ferrit umfassen kann. Die Kennlinien 405 oder 410 können in der Auswerteeinrichtung 140 abgespeichert sein, um die Position des Elements 155 auf der Basis der Induktivität der Spule 105 vereinfacht bestimmen zu können.

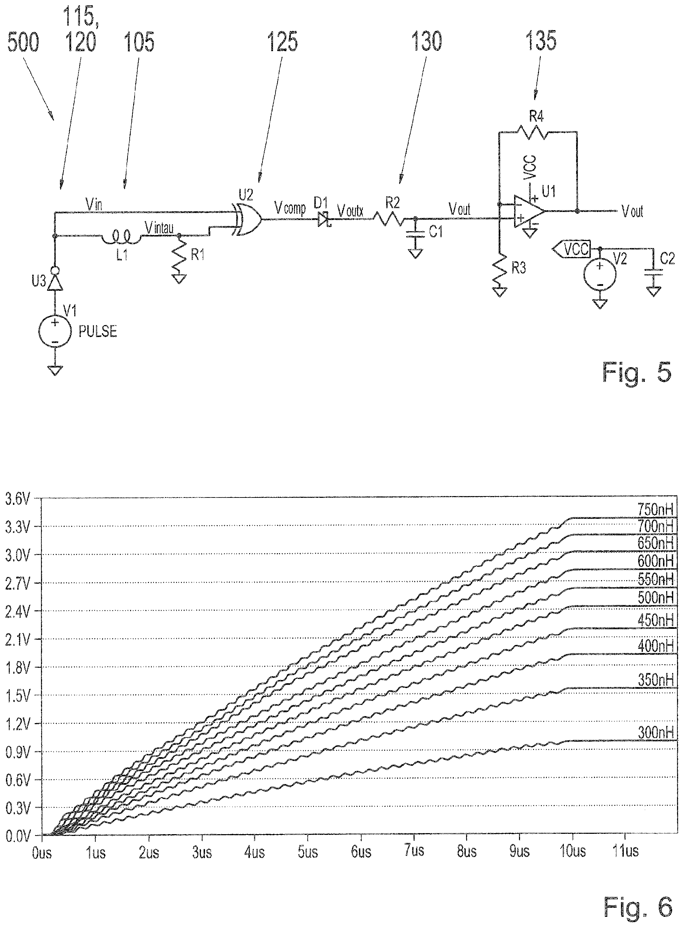

Figur 5 zeigt eine Beispielschaltung 500 für die Vorrichtung 100 von Figur 1. Figur 6 zeigt zu erwartende Spannungen am Integrator 130, wenn die Schaltung 500 mit unterschiedlich langen Impulsen durch den Signalgenerator 115 und mit unterschiedlich großen Induktivitäten der Spule 105 betrieben wird. In Figur 6 ist in horizontaler Richtung die Impulslänge und in vertikaler Richtung die resultierende Spannung am Integrator 130 für unterschiedliche Induktivitäten angetragen. Das Beispiel der Figuren 5 und 6 zeigt, wie Bauteile der Vorrichtung 100 dimensioniert werden können, um in Abhängigkeit der Induktivität der Spule 105 ein gut auszuwertendes Messsignal am Integrator 130 zu generieren.

### Bezugszeichen

- 100: Vorrichtung
- 105: Spule
- 110: Verzögerungsglied
- 115: Signalgenerator
- 120: Puffer
- 125: Vergleicher
- 130: Integrator
- 135: Verstärker
- 140: Auswerteeinrichtung
- 145: A/D-Wandler
- 150: Mikrocomputer
- 155: Element zur Beeinflussung
- 160: Widerstand

- 205: erstes Signal
- 210: zweites Signal
- 215: drittes Signal

- 305: Anordnung
- 310: Trajektorie
- 315: weichmagnetischer Kern

- 405: erste Kennlinie
- 410: zweite Kennlinie

- 500: Beispielschaltung

## Patentansprüche

1. Vorrichtung (100) zur induktiven Positionsbestimmung, umfassend:
- eine Spule (105);
- ein Element (155) zur Beeinflussung eines Magnetfelds im Bereich der Spule (105);
- einen Signalgenerator (115) zur Bereitstellung eines digitalen Signals;
- ein Verzögerungsglied (110) mit einem Eingang und einem Ausgang;
- wobei das Verzögerungsglied (110) auf der Basis der Spule (105) aufgebaut ist und eine Verzögerungszeit zwischen einer Signalflanke am Eingang und einer korrespondierenden Signalflanke am Ausgang von der Induktivität der Spule (105) abhängig ist;
- einen Vergleicher (125) zur Bereitstellung eines digitalen Differenzimpulses, dessen Länge von einer Zeitdifferenz von korrespondierenden Signalflanken am Eingang und am Ausgang des Verzögerungsglieds (110) abhängig ist;
- einen Integrator (130) zur Bereitstellung einer Spannung in Abhängigkeit der Länge des Differenzimpulses; und
- eine Auswerteeinrichtung (140) zur Bestimmung der Position (x) des Elements (155) bezüglich der Spule (105) auf der Basis der Spannung.

2. Vorrichtung (100) nach Anspruch 1, wobei das Verzögerungsglied (110) einen R-L-Tiefpass umfasst.

3. Vorrichtung (100) nach Anspruch 1 oder 2, wobei der Signalgenerator (115) abwechselnd steigende und fallende Signalflanken bereitstellt und der Vergleicher (125) dazu eingerichtet ist,
- einen ersten Differenzimpuls in Antwort auf eine steigende Signalflanke und
- einen zweiten Differenzimpuls in Antwort auf eine fallende Signalflanke bereitzustellen,
- wobei die Differenzimpulse die gleiche Polarität aufweisen
- und der Integrator (130) dazu eingerichtet ist, die Spannung in Abhängigkeit von Längen mehrerer Differenzimpulse bereitzustellen.

4. Vorrichtung (100) nach einem der vorangehenden Ansprüche, wobei die Signalflanken am Eingang und am Ausgang des Vergleichers (125) die gleiche Polarität aufweisen und der Vergleicher (125) eine XOR-Logik umfasst.

5. Vorrichtung (100) nach einem der vorangehenden Ansprüche, wobei zwei Spulen (105) vorgesehen sind, die jeweils einem Verzögerungsglied (110), einem Vergleicher (125) und einem Integrator (130) zugeordnet sind, das Element (155) so geformt ist, dass es die Magnetfelder beider Spulen (105) beeinflusst, und die Auswerteeinrichtung (140) dazu eingerichtet ist, die Position (x) des Elements (155) auf der Basis von Spannungen beider Integratoren (130) zu bestimmen.

6. Vorrichtung (100) nach einem der vorangehenden Ansprüche, wobei die Auswerteeinrichtung (140) dazu eingerichtet ist, die Position (x) des Elements (155) auf der Basis der Spannung mittels einer vorbestimmten Kennlinie zu bestimmen.

7. Vorrichtung (100) nach einem der vorangehenden Ansprüche, wobei der Integrator (130) dazu eingerichtet ist, die Spannung auf der Basis einer Anzahl Differenzimpulse bereitzustellen, und die Anzahl in Abhängigkeit einer von dem Element (155) unbeeinflussten Induktivität der Spule (105) gewählt ist.

8. Vorrichtung (100) nach einem der vorangehenden Ansprüche, wobei eine Anordnung mehrerer Spulen (105) vorgesehen ist, wobei jede Spule (105) einem Verzögerungsglied (110), einem Vergleicher (125) und einem Integrator (130) zugeordnet ist, das Element (155) auf einer Trajektorie (310) beweglich ist, die durch Bereiche der Spulen (105) führt und die Auswerteeinrichtung (140) dazu eingerichtet ist, die Position (x) des Elements (155) auf der Basis von Spannungen der Integratoren (130) bezüglich der Anordnung zu bestimmen.

9. Vorrichtung (100) nach Anspruch 8, wobei eine gemeinsame Auswerteeinrichtung (140) für mehrere Integratoren (130) vorgesehen ist und den Verzögerungsgliedern (110) das Signal des Signalgenerators (115) im Zeitmultiplexverfahren bereitgestellt wird.

10. Vorrichtung (100) nach einem der vorangehenden Ansprüche, wobei die Spule (105) eine Flachspule (105) umfasst.

11. Vorrichtung (100) nach einem der vorangehenden Ansprüche, wobei an der Spule (105) ein weichmagnetischer Kern (315) vorgesehen ist.

## Claims

1. Device (100) for inductive position determination, comprising:
- a coil (105);
- an element (155) for influencing a magnetic field in the region of the coil (105);
- a signal generator (115) for making available a digital signal;
- a delay element (110) with an input and an output;
- wherein the delay element (110) is constructed on the basis of the coil (105), and a delay between a signal edge at the input and a corresponding signal edge at the output is dependent on the inductance of the coil (105);
- a comparator (125) for making available a digital differential pulse, the length of which is dependent on a time difference between corresponding signal edges at the input and at the output of the delay element (110);
- an integrator (130) for making available a voltage as a function of the length of the differential pulse; and
- an evaluation apparatus (140) for determining the position (x) of the element (155) with respect to the coil (105) on the basis of the voltage.

2. Device (100) according to Claim 1, wherein the delay element (110) comprises an R-L low-pass filter.

3. Device (100) according to Claim 1 or 2, wherein the signal generator (115) makes available alternately rising and falling signal edges, and the comparator (125) is configured,
- to make available a first differential pulse in response to a rising signal edge and
- a second differential pulse in response to a falling signal edge,
- wherein the differential pulses have the same polarity,
- and the integrator (130) is configured to make available the voltage as a function of lengths of a plurality of differential pulses.

4. Device (100) according to one of the preceding claims, wherein the signal edges at the input and at the output of the comparator (125) have the same polarity, and the comparator (125) comprises an XOR logic.

5. Device (100) according to one of the preceding claims, wherein two coils (105) are provided which are each assigned to a delay element (110), to a comparator (125) and to an integrator (130), the element (155) is shaped in such a way that it influences the magnetic fields of the two coils (105), and the evaluation apparatus (140) is configured to determine the position (x) of the element (155) on the basis of voltages of the two integrators (130).

6. Device (100) according to one of the preceding claims, wherein the evaluation apparatus (140) is configured to determine the position (x) of the element (155) on the basis of the voltage by means of a predetermined characteristic curve.

7. Device (100) according to one of the preceding claims, wherein the integrator (130) is configured to make available the voltage on the basis of a number of differential pulses, and the number is selected as a function of an inductance, uninfluenced by the element (155), of the coil (105).

8. Device (100) according to one of the preceding claims, wherein an arrangement of a plurality of coils (105) is provided, wherein each coil (105) is assigned to a delay element (110), to a comparator (125) and to an integrator (130), the element (155) can move on a trajectory (130) which leads through regions of the coils (105), and the evaluation device (140) is configured to determine the positon (x) of the element (155) on the basis of voltages of the integrators (130) with respect to the arrangement.

9. Device (100) according to Claim 8, wherein a common evaluation apparatus (140) is provided for a plurality of integrators (130), and the signal of the signal generator (115) is made available to the delay elements (110) using the time-division multiplex method.

10. Device (100) according to one of the preceding claims, wherein the coil (105) comprises a flat coil (105).

11. Device (100) according to one of the preceding claims, wherein a soft-magnetic core (315) is provided on the coil (105).

## Revendications

1. Dispositif (100) de détermination de position par induction comprenant :
- une bobine (105) ;
- un élément (155) destiné à influer sur un champ magnétique dans la région de la bobine (105) ;
- un générateur de signal (115) destiné à délivrer un signal numérique ;
- un élément de temporisation (110) doté d'une entrée et d'une sortie ;
- dans lequel l'élément de temporisation (110) est basé sur la bobine (105) et un temps de retard entre un front de signal en entrée et un front de signal correspondant en sortie est fonction de l'inductance de la bobine (105) ;
- un comparateur (125) destiné à délivrer une impulsion différentielle numérique dont la longueur dépend d'une différence temporelle entre des fronts de signal correspondants en entrée et en sortie de l'élément de temporisation (110) ;
- un intégrateur (130) destiné à délivrer une tension en fonction de la longueur de l'impulsion différentielle ; et
- un moyen d'évaluation (140) destiné à déterminer la position (x) de l'élément (155) par rapport à la bobine (105) sur la base de la tension.

2. Dispositif (100) selon la revendication 1, dans lequel l'élément de temporisation (110) comprend un dispositif R-L passe-bas.

3. Dispositif (100) selon la revendication 1 ou 2, dans lequel le générateur de signal (115) délivre alternativement des fronts de signal montant et descendant et le comparateur (125) est conçu pour délivrer
- une première impulsion différentielle en réponse à un front de signal montant et
- une seconde impulsion différentielle en réponse à un front de signal descendant,
- dans lequel les impulsions différentielles présentent la même polarité
- et l'intégrateur (130) est conçu pour délivrer la tension en fonction de longueurs d'une pluralité d'impulsions différentielles.

4. Dispositif (100) selon l'une des revendications précédentes, dans lequel les fronts de signal en entrée et en sortie du comparateur (125) présentent la même polarité et le comparateur (125) comprend une logique XOR.

5. Dispositif (100) selon l'une des revendications précédentes, dans lequel il est prévu deux bobines (105) qui sont respectivement associées à un élément de temporisation (110), à un comparateur (125) et à un intégrateur (130), l'élément (155) est configuré de manière à influer sur les champs magnétiques des deux bobines (105) et le moyen d'évaluation (140) est conçu pour déterminer la position (x) de l'élément (155) sur la base de tensions des deux intégrateurs (130).

6. Dispositif (100) selon l'une des revendications précédentes, dans lequel le moyen d'évaluation (140) est conçu pour déterminer la position (x) de l'élément (155) sur la base de la tension au moyen d'une courbe caractéristique prédéterminée.

7. Dispositif (100) selon l'une des revendications précédentes, dans lequel l'intégrateur (130) est conçu pour délivrer la tension sur la base d'un nombre d'impulsions différentielles, et ledit nombre est sélectionné en fonction d'une inductance de la bobine (105) non soumise à l'influence de l'élément (155).

8. Dispositif (100) selon l'une des revendications précédentes, dans lequel il est prévu un agencement d'une pluralité de bobines (105), dans lequel chaque bobine (105) est associée à un élément de temporisation (110), à un comparateur (125) et à un intégrateur (130), l'élément (155) est mobile sur une trajectoire (310) qui passe à travers des régions des bobines (105) et le moyen d'évaluation (140) est conçu pour déterminer la position (x) de l'élément (155) par rapport à l'agencement sur la base de la tension de l'élément (130).

9. Dispositif (100) selon la revendication 8, dans lequel il est prévu un moyen d'évaluation (140) commun pour une pluralité d'intégrateurs (130) et le signal du générateur de signal (115) est délivré aux éléments de temporisation (110) conformément à un procédé de multiplexage par répartition dans le temps.

10. Dispositif (100) selon l'une des revendications précédentes, dans lequel la bobine (105) comprend une bobine plane (105).

11. Dispositif (100) selon l'une des revendications précédentes, dans lequel il est prévu un noyau magnétique doux (315) sur la bobine (105).
